# EUROPEAN PATENT APPLICATION

(11) **EP 3 499 570 A1**
(43) Date of publication of application: **19.06.2019**
(21) Application number: 18208956.5
(22) Date of filing: 28.11.2018
(51) Int. Cl.: H01L 25/075, G01R 31/26, H01L 21/683, H01L 33/00

(54) **ELECTRONIC DEVICE AND METHOD OF MANUFACTURING THE SAME**

(30) Priority: 13.12.2017 US 201762598021 P; 24.07.2018 CN 201810820379
(71) Applicant: InnoLux Corporation, Chu-Nan, Miao-Li 350 (TW)
(72) Inventor: HSU, Chia-Hsiu, 350 Miao-Li County (TW); CHAO, Ming-I, 350 Miao-Li County (TW); KUO, Shu-Ming, 350 Miao-Li County (TW); LIU, Yu-Hsin, 350 Miao-Li County (TW); HU, Shun-Yuan, 350 Miao-Li County (TW)
(74) Representative: 2K Patentanwälte Blasberg Kewitz & Reichel

(57) **Abstract**

A method for manufacturing an electronic device is provided. The method includes testing a plurality of first light-emitting units on a first substrate to select one of the plurality of first light-emitting unit that is to be replaced; removing the one of the plurality of first light-emitting units from the first substrate so that the first substrate has a vacant position; transferring a second light-emitting unit to a second substrate; and transferring at least part of the plurality of first light-emitting units that are not replaced from the first substrate to the second substrate. The vacant position on the first substrate corresponds to the second light-emitting unit. An electronic device manufactured by the method is also provided.

## Description

### CROSS REFERENCE TO RELATED APPLICATIONS

This application claims priority of U.S. Provisional Patent Application No. 62/598,021, filed on December 13, 2017, and Chinese Patent Application No. 201810820379.9, filed on July 24, 2018, the entirety of which are incorporated by reference herein.

### BACKGROUND

### Technical Field

The present disclosure relates to an electronic device and a method for manufacturing the electronic device. The present disclosure in particular relates to a process for replacing a light-emitting unit in the electronic device.

### Description of the Related Art

With the continuing development of portable electronic products, consumers have developed high expectations on the quality, functionality, and price of such products. Light-emitting diodes (LEDs) are expected to be widely used in future electronic products applications. Micro LED technology is an emerging electronic device technology. Micro LEDs are characterized by their minimized (or array) structure. However, since the size of a micro LED is relatively small, they are generally transferred to the destination substrate (array substrate) in a batch during the manufacturing process. An LED will need to be replaced when performance testing (including optical and electrical testing and so on) determines that the LED is inconsistent with design specifications. However, it is technically difficult to replace a micro LED due to its small size.

Accordingly, it is the object of the present disclosure to provide an electronic device and a method of manufacturing an electronic device which allows to effectively replace (or repair) micro LEDs.

### SUMMARY

This problem is decreased by an electronic device according to claim 1. The electronic device includes a substrate and a first light-emitting unit, a second light-emitting unit, a third light-emitting unit and a fourth light-emitting unit disposed on the substrate. The second light-emitting unit is adjacent to the first light-emitting unit along a first direction. The fourth light-emitting unit is adjacent to the third light-emitting unit along the first direction. The third light-emitting unit is adjacent to the first light-emitting unit along a second direction which is perpendicular to the first direction. The fourth light-emitting unit is adjacent to the second light-emitting unit along the second direction. In addition, a first pitch between the first light-emitting unit and the second light-emitting unit is different from a second pitch between the third light-emitting unit and the fourth light-emitting unit.

The problem is further decreased by a method for manufacturing an electronic device according to claim 8. The method comprises testing a plurality of first light-emitting units on a first substrate to select one of the plurality of first light-emitting units that is to be replaced; removing the one of the plurality of first light-emitting units from the first substrate so that the first substrate has a vacant position; transferring a second light-emitting unit to a second substrate; and transferring at least part of the plurality of the first light-emitting units that are not replaced from the first substrate to the second substrate. In addition, the vacant position on the first substrate corresponds to the second light-emitting unit.

A detailed description is given in the following embodiments with reference to the accompanying drawings.

### BRIEF DESCRIPTION OF THE DRAWINGS

The disclosure may be more fully understood by reading the subsequent detailed description and examples with references made to the accompanying drawings, wherein:
FIG. 1 illustrates a flowchart of a method for manufacturing an electronic device in accordance with some embodiments of the present disclosure;
FIGs. 2A-2H illustrate the cross-sectional views of the electronic device in the intermediate stages of the manufacturing in accordance with some embodiments of the present disclosure;
FIGs. 3A-3H illustrate the cross-sectional views of the electronic device in the intermediate stages of the manufacturing in accordance with some embodiments of the present disclosure;
FIG. 4A illustrates a cross-sectional view of an electronic device in accordance with some embodiments of the present disclosure;
FIG. 4B is a top-view diagram corresponding to area A in FIG. 4A;
FIG. 5 is a top-view diagram of an electronic device in accordance with some embodiments of the present disclosure;
FIG. 6 is a top-view diagram of an electronic device in accordance with some embodiments of the present disclosure;
FIG. 7 is a top-view diagram of an electronic device in accordance with some embodiments of the present disclosure;

### DETAILED DESCRIPTION

The electronic device of the present disclosure and the manufacturing method thereof are described in detail in the following description. In the following detailed description, for purposes of explanation, numerous specific details and embodiments are set forth in order to provide a thorough understanding of the present disclosure. The specific elements and configurations described in the following detailed description are set forth in order to clearly describe the present disclosure. It will be apparent, however, that the exemplary embodiments set forth herein are used merely for the purpose of illustration, and the inventive concept may be embodied in various forms without being limited to those exemplary embodiments. In addition, the drawings of different embodiments may use like and/or corresponding numerals to denote like and/or corresponding elements in order to clearly describe the present disclosure. However, the use of like and/or corresponding numerals in the drawings of different embodiments does not suggest any correlation between different embodiments. In addition, in this specification, expressions such as "first material layer disposed on/over a second material layer", may indicate the direct contact of the first material layer and the second material layer, or it may indicate a non-contact state with one or more intermediate layers between the first material layer and the second material layer. In the above situation, the first material layer may not be in direct contact with the second material layer.

It should be noted that the elements or devices in the drawings of the present disclosure may be present in any form or configuration known to those with ordinary skill in the art. In addition, the expressions "a layer overlying another layer", "a layer is disposed above another layer", "a layer is disposed on another layer" and "a layer is disposed over another layer" may indicate that the layer is in direct contact with the other layer, or that the layer is not in direct contact with the other layer, there being one or more intermediate layers disposed between the layer and the other layer.

In addition, in this specification, relative expressions are used. For example, "lower", "bottom", "higher" or "top" are used to describe the position of one element relative to another. It should be appreciated that if a device is flipped upside down, an element that is "lower" will become an element that is "higher".

It should be understood that, although the terms first, second, third etc. may be used herein to describe various elements, components, regions, layers, portions and/or sections, these elements, components, regions, layers, portions and/or sections should not be limited by these terms. These terms are only used to distinguish one element, component, region, layer, portion or section from another region, layer or section. Thus, a first element, component, region, layer, portion or section discussed below could be termed a second element, component, region, layer, portion or section without departing from the teachings of the present disclosure.

It should be understood that the descriptions of the exemplary embodiments are intended to be read in connection with the accompanying drawings, which are to be considered part of the entire written description. The drawings are not drawn to scale. In addition, structures and devices are shown schematically in order to simplify the drawing.

The terms "about" and "substantially" typically mean +/- 20% of the stated value, more typically +/- 10% of the stated value, more typically +/- 5% of the stated value, more typically +/- 3% of the stated value, more typically +/- 2% of the stated value, more typically +/- 1% of the stated value and even more typically +/- 0.5% of the stated value. The stated value of the present disclosure is an approximate value. When there is no specific description, the stated value includes the meaning of "about" or "substantially".

Unless defined otherwise, all technical and scientific terms used herein have the same meaning as commonly understood by one of ordinary skill in the art to which this disclosure belongs. It should be appreciated that, in each case, the term, which is defined in a commonly used dictionary, should be interpreted as having a meaning that conforms to the relative skills of the present disclosure and the background or the context of the present disclosure, and should not be interpreted in an idealized or overly formal manner unless so defined.

In addition, in some embodiments of the present disclosure, terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

In accordance with some embodiments of the present disclosure, a method for manufacturing the electronic device is provided. The method can replace (or repair) the light-emitting units in batches. The step for replacing the light-emitting units can replace several light-emitting units at the same time or replace the light-emitting units sequentially, and it is not limited in the present disclosure. The manufacturing method provided in the present disclosure can be unrestricted by the size of the light-emitting unit, and replace the light-emitting units of various sizes. The method can improve the replacement efficiency, quality or yield of the light-emitting unit having a smaller size.

In accordance with some embodiments of the present disclosure, an electronic device is provided. The electronic device includes a light-emitting unit that has been replaced (or repaired) using the above method. The pitch of the light-emitting units that have been replaced may be not the same as the pitch of other light-emitting units that are not replaced.

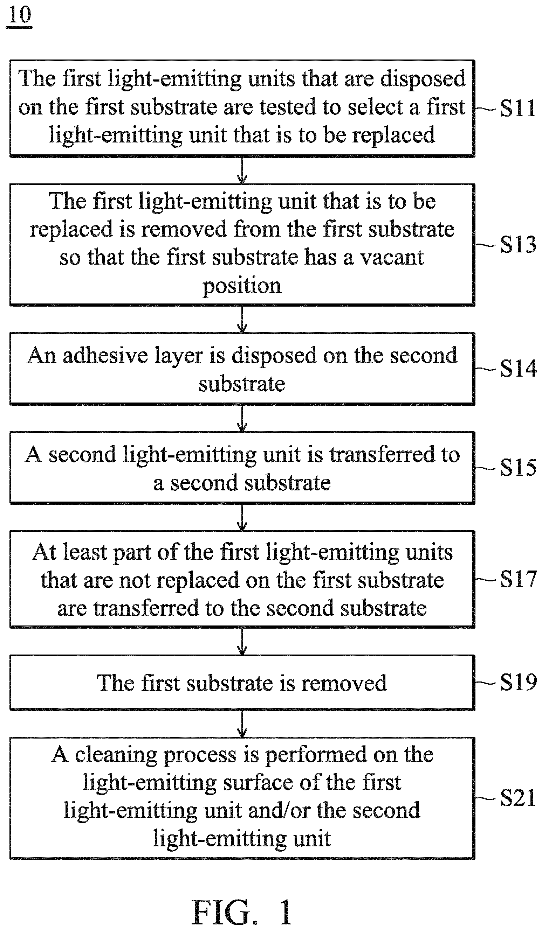

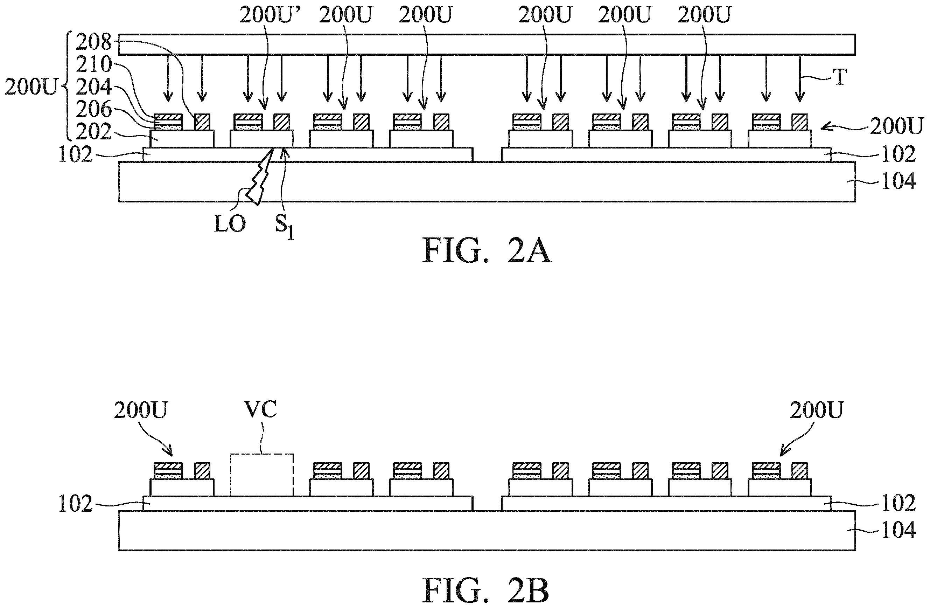

FIG. 1 illustrates a flowchart of a method for manufacturing an electronic device 10 in accordance with some embodiments of the present disclosure. In some embodiments, additional operations may be provided before, during and/or after processes in the method for manufacturing the electronic device 10. In some embodiments, some of the operations described below may be replaced or eliminated, or the order of the operations/processes may be interchangeable according to needs. In addition, additional features may be added to the electronic device, or some of the features described below may be replaced or eliminated in accordance with some embodiments. FIGs. 2A-2H illustrate the cross-sectional views of an electronic device 100A in the intermediate stages of the method 10 in accordance with some embodiments of the present disclosure.

First, refer to FIG. 1 and FIG. 2A. The method for manufacturing the electronic device 10 includes step S11, in which a plurality of first light-emitting units 200U disposed on a first substrate 102 are tested (i.e. a test T is performed) in order to select a first light-emitting unit that is to be replaced 200U'. As shown in FIG. 2A, the first substrate 102 may be disposed on a carrier substrate 104. In some embodiments, several first substrates 102 may be disposed on the carrier substrate 104. In some embodiments, the first substrate 102 may be a native substrate (or a mother substrate) or a non-native substrate (a non-mother substrate) of the plurality of first light-emitting units 200U, but it is not limited thereto. In some embodiments, the first substrate 102 may include, but is not limited to, a sapphire substrate, a glass substrate, a polymer substrate, any other applicable substrate, or a combination thereof. The material of the first substrate 102 may include, but is not limited to, silicon carbide (SiC), gallium arsenide (GaAs), gallium phosphide (GaP), any other applicable compound, or a combination thereof. In some embodiments, the carrier substrate 104 may include, but is not limited to, silicon, glass, polymer compound, metal, ceramic, or a combination thereof. The polymer substrate may include, but is not limited to, polycarbonate (PC), polyimide (PI), polyethylene terephthalate (PET), rubber, or a combination thereof.

The first light-emitting unit 200U may include, but are not limited to, light-emitting diode (LED), mini light-emitting diode (mini LED), micro light-emitting diode (micro LED), or a combination thereof.

In some embodiments, the first light-emitting unit 200U may include, for example, a first semiconductor layer 202, a second semiconductor layer 204, a quantum well layer 206 disposed between the first semiconductor layer 202 and the second semiconductor layer 204, and a first electrode 208 and a second electrode 210 that are respectively electrically connected to the first semiconductor layer 202 and the second semiconductor layer 204. The first semiconductor layer 202 and the second semiconductor layer 204 may have opposite conductive features. For example, the first semiconductor layer 202 may be a p-type semiconductor and the second semiconductor layer 204 may be an n-type semiconductor in accordance with some embodiments. In some other embodiments, the first semiconductor layer 202 may be an n-type semiconductor and the second semiconductor layer 204 may be a p-type semiconductor.

In some embodiments, the first semiconductor layer 202 and the second semiconductor layer 204 may be formed of gallium nitride (GaN), but is not limited thereto. In some embodiments, the quantum well layer 206 may include a single quantum well (SQW) or a multiple quantum well (MQW). The material of the quantum well layer 206 may include, but is not limited to, indium gallium nitride (InGaN), gallium nitride (GaN), or a combination thereof. The first electrode 208 and the second electrode 210 may serve as p-electrode/n-electrode of the light-emitting unit 200U in accordance with some embodiments. In some embodiments, the first electrode 208 and the second electrode 210 may be formed of metallic conductive materials, transparent conductive materials or a combination thereof. The metallic conductive material may include, but is not limited to, copper, aluminum, tungsten, titanium, gold, platinum, nickel, copper alloys, aluminum alloys, tungsten alloys, titanium alloys, gold alloys, platinum alloys, nickel alloys, any other applicable conductive materials, or a combination thereof. The transparent conductive material may include transparent conductive oxides (TCO) such as indium tin oxides (ITO), tin oxides (SnO), zinc oxides (ZnO), indium zinc oxides (IZO), indium gallium zinc oxides (IGZO), indium tin zinc oxides (ITZO), antimony tin oxides (ATO), antimony zinc oxides (AZO), or a combination thereof, but it is not limited thereto.

It should be understood that although the light-emitting units illustrated in the figures are flip-chip type light-emitting diodes, the present disclosure are not limited thereto. The light-emitting units may be vertical type light-emitting diodes in accordance with some other embodiments.

The above test T may be used to test whether the quality or performance of the first lighting-unit 200U conforms to design specifications. In some embodiments, the test T may be used to test the photoelectric properties of the first lighting-unit 200U, but the present disclosure is not limited thereto. The test T may be carried out using suitable methods known in the art according to needs. In some embodiments, a first light-emitting unit that is to be replaced 200U' may be selected by analyzing the results of the test T. For example, the first light-emitting unit that is to be replaced 200U' may be a light-emitting unit whose photoelectric properties do not conform to design specifications or an abnormal light-emitting unit, but it is not limited thereto. For example, the light-emitting unit that is to be replaced may be referred to the light-emitting unit that flickers, constantly emits light or emits weak light when an off signal is given by an induced current or a driving circuit; or may be referred to the light-emitting unit that flickers, emits weak light or does not emit light when an on signal is given by an induced current or a driving circuit. Alternatively, in accordance with some embodiments, the light-emitting unit that is to be replaced (or the abnormal light-emitting unit) may be referred to the light-emitting unit whose brightness, wavelength, or voltage does not conform to design specifications, but the present disclosure is not limited thereto. In some embodiments, the light-emitting unit that is to be replaced (or the abnormal light-emitting unit) may be, for example, a light-emitting unit whose appearance is significantly damaged or deformed. It should be understood that although only one of the plurality of first light-emitting units that is to be replaced 200U' is illustrated in the figure, the first substrate 102 may actually include plural first light-emitting units that are to be replaced 200U'.

Next, continue to refer to FIG. 1 and FIG. 2A. In step S13, one of the plurality of first light-emitting units that is to be replaced 200U' is removed from the first substrate 102. A removal process LO may be performed to remove the first light-emitting unit that is to be replaced 200U' from the first substrate 102. As shown in FIG. 2B, after the first light-emitting unit that is to be replaced 200U' is removed, a vacant position VC is formed on the first substrate 102. In some embodiments, the removal process LO may include, but is not limited to, a laser lift-off (LLO) process, a dry (or wet) chemical etching process, a laser bombardment process, any other applicable process, or a combination thereof. For example, the removal process LO may lift off an interface S₁ between the first substrate 102 and the first light-emitting unit 200U'.

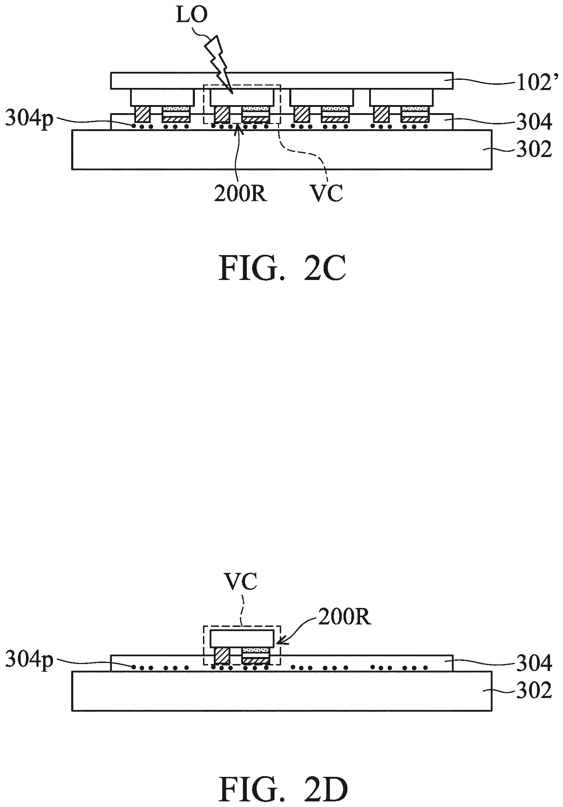

Next, refer to FIGs. 1, 2C, and 2D. In step S15, a second light-emitting unit 200R is transferred to a second substrate 302. The position of the second light-emitting unit 200R corresponds to the vacant position VC on the first substrate 102 (i.e. the first light-emitting unit that is to be replaced 200U'). Specifically, if there is no first light-emitting unit that is to be replaced 200U' on the first substrate 102, the plurality of first light-emitting units 200U on the first substrate 102, for example, may be transferred to the second substrate 302 (e.g., a destination substrate). This process may include alignment of the first substrate 102 with the second substrate 302 (e.g., through alignment marks and so on, but the present disclosure is not limited thereto). However, if there is first light-emitting unit that is to be replaced 200U' on the first substrate 102, the first light-emitting unit that is to be replaced 200U' may be removed from the first substrate 102. After the first light-emitting unit 200U' is removed, the vacant position VC will be formed (or exist) on the first substrate 102. At least part of the plurality of first light-emitting units 200U that are not replaced (i.e. that do not need replacement) on the first substrate 102 are transferred to the second substrate 302 (e.g., the destination substrate), and this transferring step may be conducted at least one more time. In addition, the second light-emitting unit 200R (which is a light-emitting unit for replacing the first light-emitting unit that is to be replaced 200U') on another first substrate 102' is also transferred to the second substrate 302. For example, the above transfer steps may require the first substrate 102 or another first substrate 102' to be aligned with the second substrate 302. In order to facilitate the transfer or reduce the mutual influence among the plurality of first light-emitting units 200U or the second light-emitting units 200R on the second substrate 302, the position of the second light-emitting unit 200R on the first substrate 102' may correspond to the vacant position VC on the substrate 102 in advance. For example, if the vacant position VC on the first substrate 102 is located at the second position, the second light-emitting unit 200R at the second position on the first substrate 102' may be transferred. The at least part of the plurality of first light-emitting units 200U on the first substrate 102 that are not replaced may be transferred to the second substrate 302 first, or the second light-emitting unit 200R on another first substrate 102' may be transferred to the second substrate 302 first, and the order is not particularly limited in the present disclosure. The details are described in the following context.

In some embodiments, the first substrate 102' may include at least one second light-emitting unit 200R. In some embodiments, the first light-emitting unit that is to be replaced 200U' and the second light-emitting unit 200R may be the light-emitting units that emit light having substantially the same wavelength (for example, blue light, green light, or red light, but it is not limited thereto). The pitch between the second light-emitting units 200R on the first substrate 102' is substantially the same as the pitch between the at least part of the plurality of first light-emitting units 200U on the first substrate 102 in accordance with some embodiments. The size of the second light-emitting unit 200R on the first substrate 102' is substantially the same as the size of the first light-emitting unit 200U on the first substrate 102 in accordance with some embodiments. In some embodiments, the second light-emitting units 200R formed on the first substrate 102' may be an array of light-emitting units dedicated to replacement (or repair). In some embodiments, the second light-emitting units 200R on the first substrate 102' may have been tested in the test T, and it has been confirmed that their performance meets design specifications.

In some embodiments, the second light-emitting unit 200R, which corresponds to the vacant position VC, on the first substrate 102' may be removed in the removal process LO so that the second light-emitting unit 200R may be transferred onto the second substrate 302. In some embodiments, the removal process LO may include, but is not limited to, a laser lift-off (LLO) process, a dry (or wet) chemical etching process, a laser bombardment process, any other applicable process, or a combination thereof.

It should be understood that although only one light-emitting unit is removed or replaced in the illustrated embodiment, several light-emitting units may be removed or replaced simultaneously in accordance with other embodiments. In other words, several vacant positions VC may be formed on the first substrate 102, and they may be replaced by several second light-emitting units 200R corresponding to the vacant positions VC, which are disposed on another first substrate 102'.

In addition, as shown in FIGs. 2C and 2D, the method for manufacturing the electronic device 10 further comprises step S14 in accordance with some embodiments. In step S14, an adhesive layer 304 may be disposed on the second substrate 302 before the second light-emitting unit 200R is transferred to the second substrate 302 (step S15). The adhesive layer 304 may be used to temporarily locate the second light-emitting unit 200R on the second substrate 302. In some embodiments, the material of the adhesive layer 304 may include, but is not limited to, photo-curable material, thermo-curable material, photothermal-curable material, moisture-curable material, any other applicable material, or a combination thereof. The second light-emitting unit 200R may be partially embedded in the adhesive layer 304 in accordance with some embodiments. In some embodiments, the adhesive layer 304 may be slightly adhesive before curing, and the position of the second light-emitting unit 200R on the adhesive layer 304 may be moderately adjusted, and the risk of contact or short-circuit between different light-emitting units may be reduced.

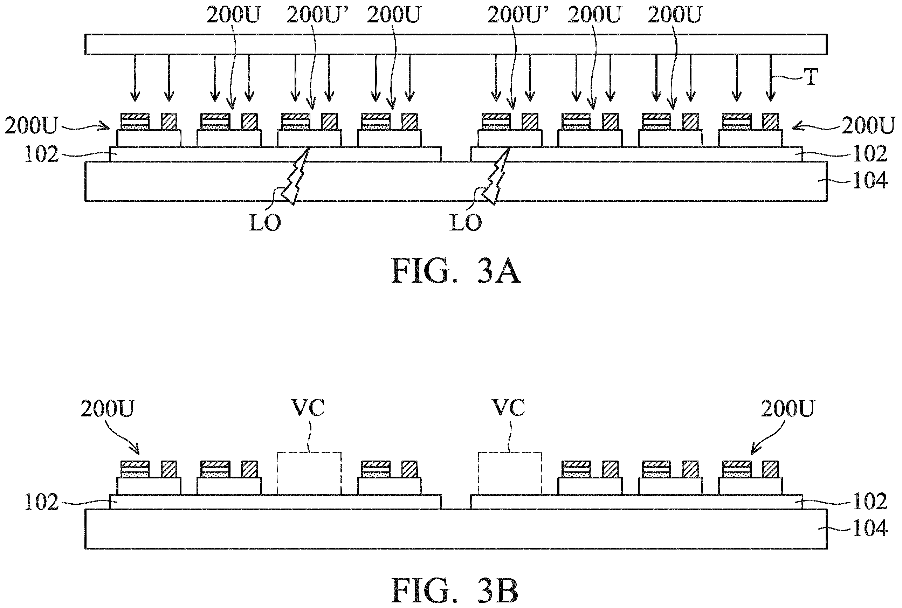

In some embodiments, the adhesive layer 304 may include, but is not limited to, an anisotropic conductive film (ACF), an anisotropic conductive paste (ACP), a non-conductive film (NCF), a non-conductive paste (NCP), a photoresist, or a combination thereof. The anisotropic conductive film (ACF) or the anisotropic conductive paste (ACP) may include polymer materials and conductive particles (indicated as 304p in the figure). The conductive particles may provide electrical connection, for example, between the light-emitting units and the conductive pads on the destination substrate (e.g., an array substrate, but it is not limited thereto). In the embodiments where a non-conductive film (NCF), a non-conductive paste (NCF), or a photoresist is used as the adhesive layer 304, the at least part of the plurality of first light-emitting units 200U that are not replaced and the second light-emitting unit 200R may be bonded to or electrically connected to the destination substrate (e.g., an array substrate) by a eutectic bonding process (as shown in FIGs. 3A-3H). In addition, in some embodiments, the adhesive layer 304 may be formed by coating, spraying, screen-printing, attaching, transfer, photolithography process, any other applicable process, or a combination thereof, but it is not limited thereto. The adhesive layer 304 may have a single-layered structure or a multi-layered structure in accordance with some embodiments.

In some embodiments, plural first light-emitting units that are to be replaced may be selected. After the plural first light-emitting units that are to be replaced 200U' are removed, plural vacant positions VC may be formed (or existed) on the first substrate 102. The corresponding plural second light-emitting units 200R are transferred to replace the plural first light-emitting units that are to be replaced 200U'. In other words, after removing at least one first light-emitting unit that is to be replaced, and at least one vacant position VC may be formed on the substrate.

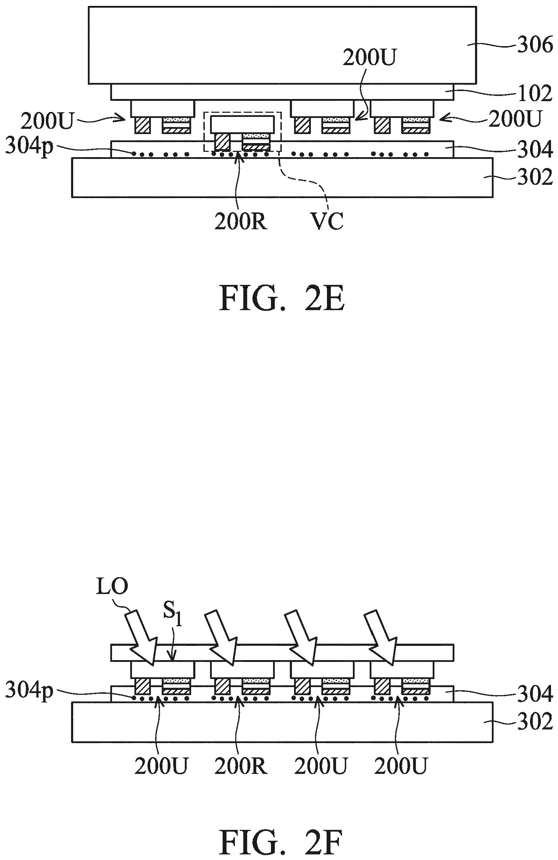

Next, refer to FIG. 1 and FIG. 2E. In step S17, the at least part of the plurality of first light-emitting units 200U that are not replaced on the first substrate 102 are transferred to the second substrate 302. In other words, the at least part of the plurality of the first light-emitting units 200U on the first substrate 102, which includes the vacant position VC shown in FIG. 2B, are transferred onto the second substrate 302. Specifically, in some embodiments, the first substrate 102 having the vacant position VC may be removed from the carrier substrate 104 first, and then the first substrate 102 (with the vacant position VC) may be grabbed or transferred by a device 306 and the first light-emitting units 200U on the first substrate 102 may be transferred to the second substrate 302. Specifically, the at least part of the plurality of the first light-emitting units 200U that are not replaced may be referred to a part of the first light-emitting units 200U that are not replaced on the first substrate 102 or all of the first light-emitting units 200U that are not replaced on the first substrate 102. In other words, the at least part of the plurality of the first light-emitting units 200U that are not replaced may be equally or unequally divided into subgroups to transfer to the second substrate 302 respectively. Alternatively, the at least part of the plurality of the first light-emitting units 200U that are not replaced may be transferred to the second substrate 302 at one time (in whole).

In some embodiments, the first substrate 102 may be aligned with the second substrate 302 first, and then the at least part of the plurality of first light-emitting units 200U on the first substrate 102 are transferred to the second substrate 302. For example, the alignment may include, but is not limited to, optical alignment or mechanical alignment. In addition, the step of alignment may be not necessary in accordance with some embodiments. In some embodiments, the device 306 may grab the first substrate 102 by using, for example, vacuum, static electricity, magnetic force, or van der Waals force, but it is not limited thereto. Moreover, as shown in FIG. 2E, the first light-emitting units 200U may avoid being positioned on the second substrate 302 where the second light-emitting unit 200R is located, and may instead be temporarily positioned in the adhesive layer 304. In some embodiments, the at least part of the plurality of first light-emitting units 200U may be also partially embedded in the adhesive layer 304.

In addition, the second substrate 302 may be an array substrate (or a destination substrate) in accordance with some embodiments. The material of the second substrate 302 may include, but is not limited to, glass, quartz, sapphire, plastics, polymers, other applicable materials, or a combination thereof. For example, the second substrate 302 may serve as a driving substrate of the electronic device 100A. Specifically, the second substrate 302 may include a driving circuit (not illustrated), and the driving circuit may be, for example, an active driving circuit or a passive driving circuit. For example, the driving circuit may include, but is not limited to, a transistor (such as a switching transistor, a driving transistor, or other transistors), a data line, a scan line, a conductive pad, or a dielectric layer or other wiring. The switching transistor may be used to turn the first light-emitting unit 200U or the second light-emitting 200R on and off. In some embodiments, the driving circuit may control the first light-emitting unit 200U or the second light-emitting unit 200R by using an external integrated circuit (IC) or a microchip. In some embodiments, the second substrate 302 may serve as an intermediate substrate that temporarily carries the first light-emitting units 200U or the second light-emitting units 200R (as shown in the embodiments of FIGs. 3A-3H).

In some embodiments, step S15 and step S17, which are described above, may be interchangeable. In other words, the at least part of the plurality of first light-emitting units 200U on the first substrate 102 may be transferred to the second substrate 302 first, and then the second light-emitting unit 200R on the first substrate 102' may be transferred to the second substrate 302. However, it should be noted that the at least part of the plurality of first light-emitting units 200U and the second light-emitting unit 200R need to be avoided from overlapping each other on the second substrate 302. That is, the at least part of the plurality of first light-emitting unit 200U and the second light-emitting unit 200R are electrically connected to different respective conductive pads (which are not illustrated, but they are described below) on the second substrate 302.

Next, refer to FIG.1 and FIG. 2F. In step S19, the first substrate 102 may be removed in the removal process LO. The removal process LO may include the processes as described above. For example, a dry (or wet) chemical etching process may be used in the removal process LO to etch away the first substrate 102 directly. For example, the removal process LO may lift off the interface S₁ between the first substrate 102 and the at least part of the plurality of first light-emitting unit 200U or between the first substrate 102 and the second light-emitting unit 200R.

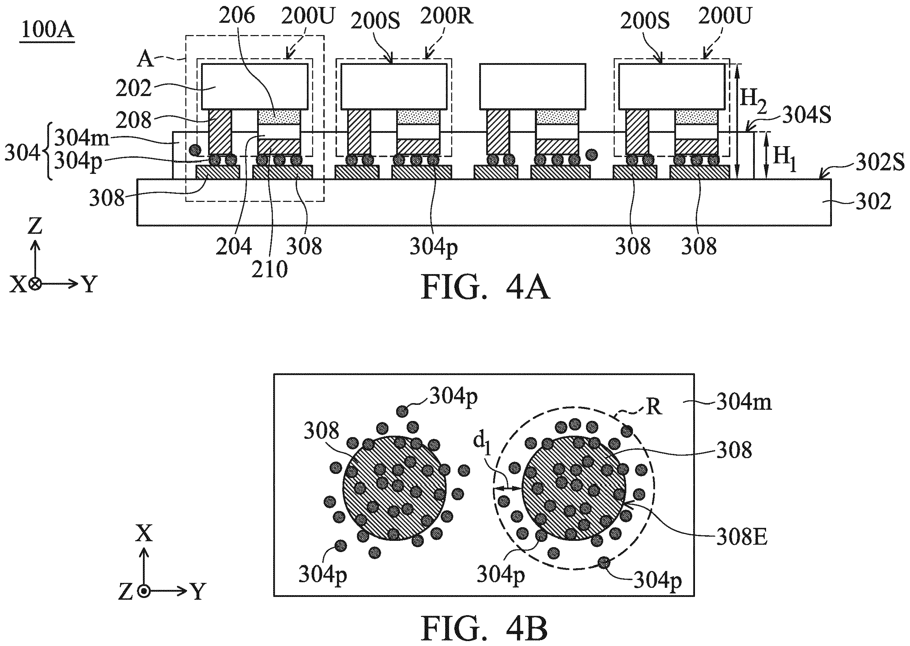

In addition, in some embodiments, before the first substrate 102 is removed (step S19), a curing process may be performed on the adhesive layer 304 to fix the at least part of the plurality first light-emitting unit 200U and the second light-emitting unit 200R in the adhesive layer 304. In some embodiments where the adhesive layer 304 includes thermo-curable materials, a heating step may be performed on the adhesive layer 304 to carry out the curing process. In some embodiments, the temperature of the heating step is in a range from about 100 °C to about 400 °C, but it is not limited thereto. In some embodiments, the pressure of the curing process is in a range from about 1 Mpa to about 80 Mpa, but it is not limited thereto. In some embodiments where the adhesive layer 304 includes photo-curable materials, the adhesive layer 304 may be irradiated with light of a specific wavelength to carry out the curing process. For example, the adhesive layer 304 may be irradiated with UV light or visible light in accordance with some embodiments. In some embodiments, the adhesive layer 304 may be placed for a period of time to effect the curing process. Moreover, in some embodiments, the adhesive layer 304 may be patterned and disposed on the second substrate 302. In some embodiments, the adhesive layer 304 may also serve as an underfill of the bottom of the light-emitting unit. The configuration of underfill may reduce the probability of short circuit between adjacent light-emitting units or reduce the corrosion of the conductive pads (for example, the conductive pads 308 shown in FIG. 4A).

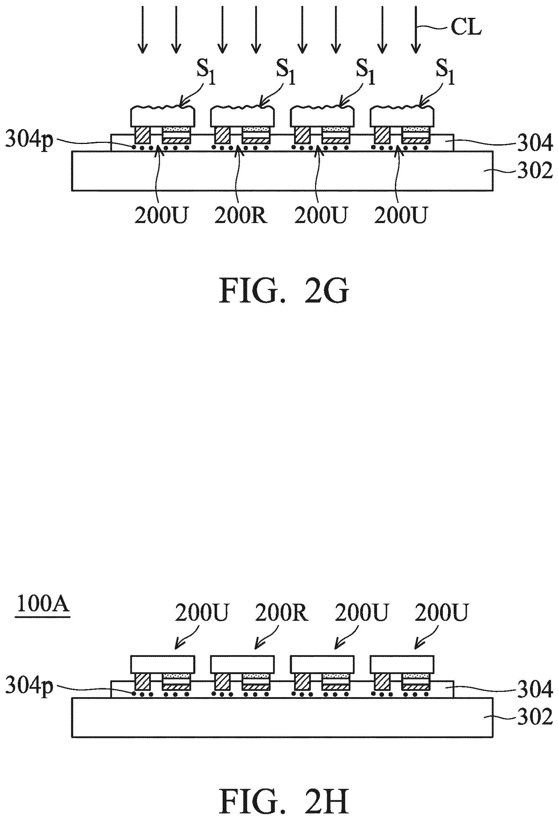

Next, refer to FIG. 1 and FIG. 2G. The method for manufacturing the electronic device 10 further comprises step S21 in accordance with some embodiments. In step S21, a cleaning process CL is performed on the light-emitting surfaces of the at least part of the plurality of first light-emitting units 200U and/or the second light-emitting unit 200R. In some embodiments, the light-emitting surface may be, for example, the top surface of the first semiconductor layer 202 of the first light-emitting unit 200U or the second light-emitting unit 200R. In some embodiments, the energy that is generated in the removal process may cause the top surface (interface S₁) of the first semiconductor layer 202 of the at least part of the plurality of first light-emitting unit 200U or the second light-emitting unit 200R to become rough. In some embodiments, the roughness of the top surface (interface S₁) of the first semiconductor layer 202 of the at least part of the plurality of first light-emitting unit 200U or the second light-emitting unit 200R is in a range from about 0.1µm to about 2µm. In some embodiments, the roughness of the top surface (interface S₁) of the first semiconductor layer 202 of the at least part of the plurality of first light-emitting unit 200U or the second light-emitting unit 200R is in a range from about 0.1µm to about 0.5µm.

Furthermore, in some embodiments, the light-emitting surface of the at least part of the plurality of first light-emitting unit 200U or the second light-emitting unit 200R is cleaned by an etching step, and the roughness of the light-emitting surface of the at least part of the plurality of first light-emitting unit 200U or the second light-emitting unit 200R may be changed and therefore the transmission pathway of light may be altered or adjusted. In some embodiments, the etching step includes, but is not limited to, a wet etching process.

The electronic device 100A is substantially completed at this stage. As shown in FIG. 2H, the at least part of the plurality of first light-emitting units 200U and the second light-emitting unit 200R are disposed on the second substrate 302, and the at least part of the plurality of first light-emitting units 200U and the second light-emitting unit 200R are fixed by the adhesive layer 304. In addition, in some embodiments, the test T (not illustrated) may be performed on the assembled electronic device 100A to test whether the performance of the at least part of the plurality of first light-emitting unit 200U or the second light-emitting unit 200R is normal.

Next, refer to FIGs. 3A-3H, which illustrate cross-sectional views of an electronic device 100B in the intermediate stages of the method 20 in accordance with some other embodiments of the present disclosure. It should be understood that the same or similar components or elements in the contexts are represented by the same or similar reference numerals. The materials, manufacturing methods and functions of these components or elements are the same or similar to those described above, and thus will not be repeated herein. The method for manufacturing the electronic device 20 shown in FIGs. 3A-3H is similar to the method for manufacturing the electronic device 10 shown in FIGs. 2A-2H. The difference between them is that the first light-emitting units 200U disposed on the different first substrates 102 can be replaced (or repaired) at the same time in the embodiments illustrated in FIGs. 3A-3H. In other words, the first light-emitting units 200U that are disposed on several first substrates 102 can be replaced (or repaired) at the same time.

Specifically, as shown in FIG. 3A, a test T is performed on a plurality of first light-emitting units 200U disposed on the first substrate 102 to select the first light-emitting units that are to be replaced 200U'. In particular, the first light-emitting units that are to be replaced 200U', and which are disposed on different first substrates 102, can be selected by analyzing the results of the test T. Next, a removal process LO may be performed to remove from the first substrate 102 the first light-emitting units that are to be replaced 200U'. Therefore, vacant positions VC corresponding to the first light-emitting units that are to be replaced 200U' may be formed on different first substrates 102 (as shown in FIG. 3B).

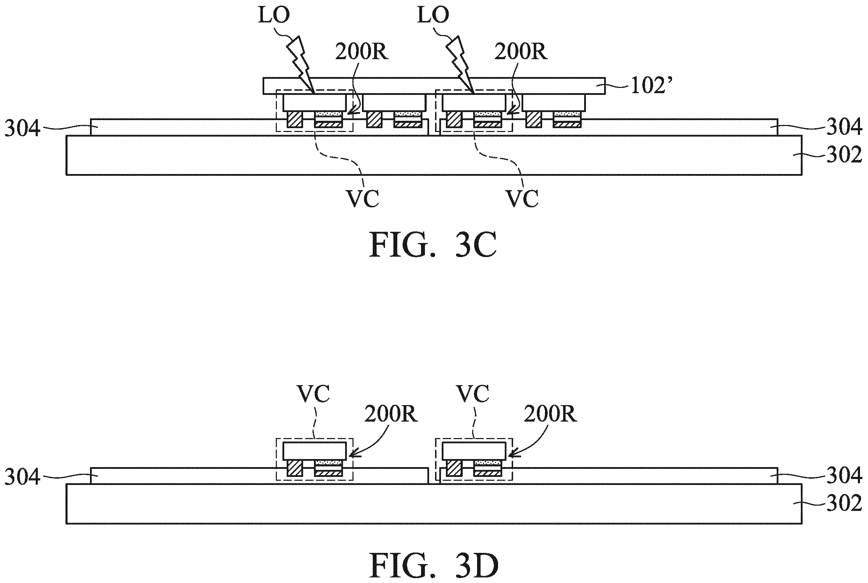

Next, as shown in FIGs. 3C and 3D, the second light-emitting units 200R on the first substrate 102' are transferred to the second substrate 302 simultaneously or in batches. The positions where the second light-emitting units 200R are disposed correspond to the vacant positions VC of the first light-emitting units that are to be replaced 200U' on the first substrate 102. Specifically, in this embodiment, the second light-emitting units 200R disposed on the same first substrate 102' may be used, for example, to replace the first light-emitting units 200U' that are disposed on the different first substrates 102 simultaneously or in batches. In some embodiments, the first light-emitting units 200U' that are disposed on two or more first substrates 102 may be replaced at the same time or in batches, but it is not limited thereto. In addition, in this embodiment, the adhesive layer 304 may be formed on the second substrate 302 before the second light-emitting units 200R are transferred to the second substrate 302. In some embodiments, the adhesive layer 304 that is disposed on the second substrate 302 may be continuous or discontinuous (i.e. the patterned adhesive layer 304) according to needs of subsequent process.

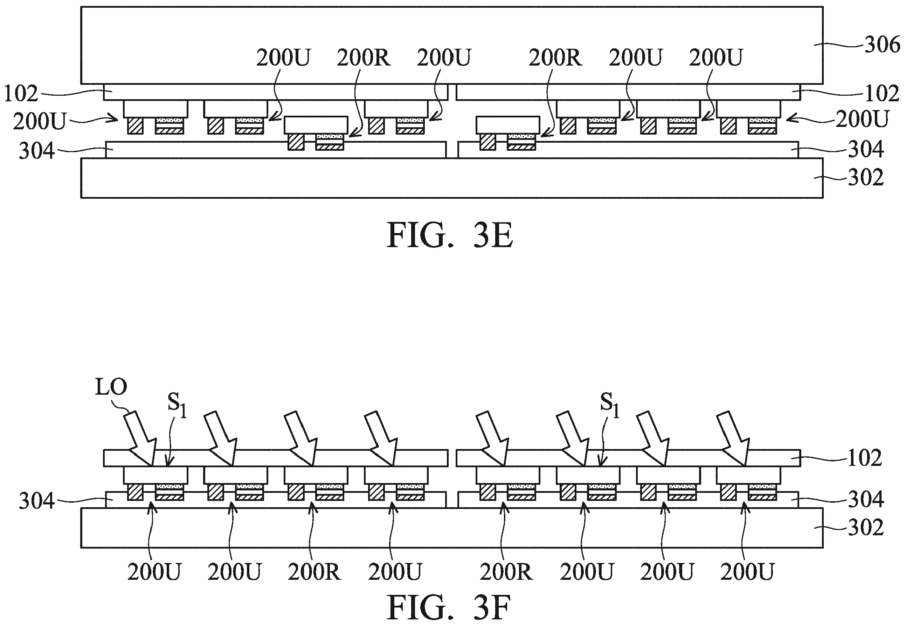

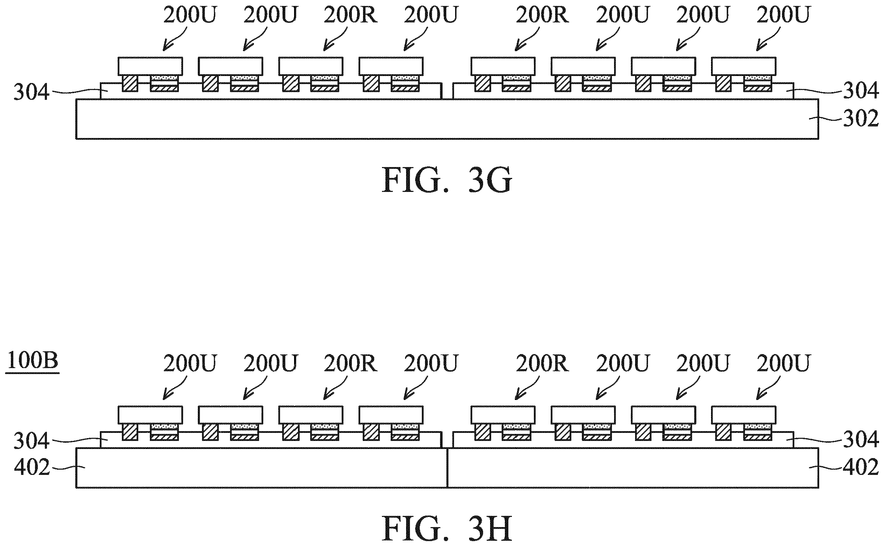

Next, as shown in FIG. 3E, the at least part of the plurality of first light-emitting units 200U that are not replaced on the first substrate 102 may be transferred to the second substrate 302 respectively. As shown in FIG. 3E, the at least part of the plurality of first light-emitting units 200U may avoid being positioned on the second substrate 302 where the second light-emitting units 200R are located, and instead they may be temporarily positioned in the adhesive layer 304. The at least part of the plurality of first light-emitting units 200U and the second light-emitting units 200R may be partially embedded in the adhesive layer 304. Next, as shown in FIG. 3F, the first substrates 102 may be removed in the removal process LO. For example, the removal process LO may lift off the interface S₁ between the first substrate 102 and the first light-emitting unit 200U' or between the first substrate 102 and the second light-emitting unit 200R. In some embodiments, after the removal process, the cleaning process CL may performed on the light-emitting surface of the at least part of the plurality of first light-emitting unit 200U and/or the second light-emitting unit 200R. Thereafter, as shown in FIG. 3G, the at least part of the plurality of first light-emitting units 200U and the replaced second light-emitting units 200R may be temporarily fixed to the second substrate 302 by the adhesive layer 304. In some embodiments, the adhesive layer 304 or the second substrate 302 may be flexible. The distance between the at least part of the plurality of first light-emitting unit 200U and the second light-emitting unit 200R formed on the second substrate 302 may be adjusted by stretching the adhesive layer 304 or the second substrate 302. With such a configuration, the quality of the electronic device may be increased and the probability of short circuit between the light-emitting units due to being too close to each other may be reduced.

In this embodiment, the second substrate 302 may serve as an intermediate substrate for temporarily carrying the at least part of the plurality of first light-emitting units 200U or the second light-emitting units 200R that need to be replaced on different first substrates 102. Next, as shown in FIG. 3H, the second substrate 302 may be removed, and the adhesive layer 304 and the at least part of the plurality of first light-emitting units 200U or the second light-emitting units 200R that are temporarily fixed on the second substrate 302 may be transferred onto a third substrate 402. In this embodiment, the third substrate 402 may be an array substrate. For example, the third substrate 402 may serve as a driving substrate of the electronic device. Specifically, the third substrate 402 may include a driving circuit (not illustrated), and the descriptions regarding the drive substrate are as described above, and thus will not be repeated herein. In some embodiments, the above adhesive layer 304, and the at least part of the plurality of first light-emitting units 200U and the second light-emitting units 200R formed on the adhesive layer 304 may be transferred to the different third substrates 402 or the same third substrate 402.

In this embodiment, the at least part of the plurality of first light-emitting units 200U that are not replaced or the second light-emitting unit 200R may be bonded to the third substrate 402 by a eutectic bonding process. Specifically, the at least part of the plurality of first light-emitting unit 200U or the second light-emitting unit 200R may be electrically connected to the third substrate 402 by, for example, the eutectic bonding process. In some embodiments, the electronic device 100B that is formed may be a tiled display, and the at least part of the plurality of first light-emitting unit 200U and the replaced second light-emitting unit 200R may be disposed on different third substrates 402 that are adjacent to each other, but the present disclosure is not limited thereto.

Next, refer to FIG. 4A, which illustrates a cross-sectional view of the electronic device 100A in accordance with some embodiments of the present disclosure. As described above, the material of the adhesive layer 304 may include an anisotropic conductive film (ACF) or an anisotropic conductive paste (ACP) in accordance with some embodiments. Specifically, the adhesive layer 304 may include polymer materials in a matrix 304m and the conductive particles 304p distributed therein in accordance with some embodiments. In some embodiments, the polymer materials may include, but are not limited to, organic materials. The polymer materials may include, but are not limited to, epoxy, acrylic resins such as polymethylmetacrylate (PMMA), benzocyclobutene (BCB), polyimide, polyester, polydimethylsiloxane (PDMS), any other applicable material, or a combination thereof. In addition, in some embodiments, the conductive particle 304p may include, but is not limited to, a compressible polymer whose surface coated with conductive materials, a solder ball, or a combination thereof. The conductive materials may include, but are not limited to, nickel (Ni), gold (Au), platinum (Pt), silver (Ag), copper (Cu), iron (Fe), tin (Sn), aluminum (Al), magnesium (Mg), palladium (Pd), iridium (Ir), rhodium (Rh), ruthenium (Ru), zinc (Zn), nickel alloys, gold alloys, platinum alloys, silver alloys, copper alloys, iron alloys, tin alloys, aluminum alloys, magnesium alloys, palladium alloys, iridium alloys, rhodium alloys, ruthenium alloys, zinc alloys, any other applicable conductive material, or a combination thereof. In some embodiments, the particle size of the conductive particle 304p may be in a range from about 1 µm to about 30 µm. In some embodiments, the particle size of the conductive particle 304p may be in a range from about 1 µm to about 10 µm.

As shown in FIG. 4A, the conductive particles 304p in the adhesive layer 304 may be disposed between the electrodes of the at least part of the plurality of first light-emitting units 200U or the second light-emitting unit 200R (e.g., the first electrode 208 or the second electrode 210) and the conductive pads 308 disposed on the second substrate 302 in accordance with some embodiments. For example, the second substrate 302 may serve as an array substrate, and the conductive pad 308 may be electrically connected to a driving circuit disposed on the second substrate 302. In some embodiments, the conductive particles 304p may be in contact with the electrodes of the first light-emitting unit 200U or the second light-emitting unit 200R (e.g., the first electrode 208 or the second electrode 210) and the conductive pad 308 so that the at least part of the plurality of first light-emitting unit 200U may be electrically connected to the conductive pad 308 disposed on the second substrate 302, and the second light-emitting unit 200R may be electrically connected to the conductive pad 308 disposed on the second substrate 302. In addition, as shown in FIG. 4A, most of the conductive particles 304p may be disposed between the at least part of the plurality of first light-emitting units 200U and the conductive pad 308 that is disposed on the second substrate 302, or between the second light-emitting unit 200R and the conductive pad 308 that is disposed on the second substrate 302.

In some embodiments, the conductive pad 308 may be formed of metallic conductive materials, transparent conductive materials or a combination thereof. The metallic conductive material may include, but is not limited to, copper (Cu), aluminum (Al), molybdenum (Mo), tungsten (W), gold (Au), chromium (Cr), nickel (Ni), copper alloys, aluminum alloys, molybdenum alloys, tungsten alloys, gold alloys, chromium alloys, nickel alloys, any other applicable material, or a combination thereof. The transparent conductive material may include, but is not limited to, indium tin oxides (ITO), tin oxides (SnO), indium zinc oxides (IZO), indium gallium zinc oxides (IGZO), indium tin zinc oxides (ITZO), any other applicable material, or a combination thereof.

Furthermore, as shown in FIG. 4A, the adhesive layer 304 may have a first height H₁, and the first light-emitting unit 200U or the second light-emitting unit 200R may have a second height H₂. For example, the first height H₁ may be defined as the maximum distance between the top surface 302S of the second substrate 302 and the top surface 304S of the adhesive layer 304 in the normal direction of the second substrate 302 (along the Z direction). For example, the second height H₂ may be defined as the maximum distance between the top surface 302S of the second substrate 302 and the top surface 200S of the first light-emitting unit 200U or the second light-emitting unit 200R in the normal direction of the second substrate 302 (along the Z direction). In some embodiments, the second H₂ may be greater than the first height H₁. In some embodiments, the adhesive layer 304 may include light-shielding materials or light-absorbing materials. In other words, the adhesive layer 304 may serve as a light-shielding layer of the first light-emitting unit 200U or the second light-emitting unit 200R, and therefore a light-shielding layer may not need to be additionally disposed on the second substrate 302.

Next, refer to FIG. 4B, which is a top-view diagram corresponding to area A in FIG. 4A (the top-view diagram in the X-Y plane). It should be understood that some of the elements, such as the first light-emitting unit 200U, are omitted in FIG. 4B to clearly illustrate the conductive particles 304p and the conductive pads 308. As shown in FIG. 4B, the adhesive layer 304 may include the conductive particles 304p that are arranged in a pattern (i.e. the conductive particles 304p have a patterned arrangement). Specifically, the conductive particles 304p may be arranged corresponding to the position of the conductive pad 308, and the conductive particles 304p may be arranged corresponding to the position of the electrode of the light emitting-unit (e.g., the first electrode 208 and the second electrode 210). In other words, most of the conductive particles 304p may overlap the conductive pad 308 or the electrode of the light-emitting unit (e.g., the first electrode 208 and the second electrode 210) in the normal direction of the matrix 304m. The phrase "the conductive particles 304p may be arranged corresponding to the position of the conductive pad 308" may be referred to the situation that most of the conductive particles 304p fall within the area of the conductive pad 308 (e.g., in the normal direction of the conductive pad 308) while few conductive particles 304p fall outside of the area of the conductive pad 308.

In some embodiments, the conductive particles 304p may surround the conductive pad 308, and the region where the conductive particles 304p are disposed or distributed may be defined as a region R. In some embodiments, the distance d₁ between the region R and an outer edge 308E of the conductive pad 308 may be in a range from about 0 µm to about 30 µm. As described above, the patterned arrangement of the conductive particles 304p may reduce the amount of conductive particles 304p that is used in the adhesive layer 304, and may reduce occurrence of short circuit caused by the conductive particles 304p that are disposed on different conductive pads 308 being too close to each other. In some embodiments, the adhesive layer 304 may include the conductive particles that are arranged in an array (not illustrated). That is, the conductive particles 304p may be disposed in the adhesive layer 304 with regularity. However, in some embodiments, the arrangement of the conductive particles 304p in the adhesive layer 304 may be unpatterned, for example, the conductive particles 304p may be randomly distributed in the adhesive layer 304.

In addition, it should be understood that the shape of the conductive pad 308 is not limited to the circular shape as shown in the figure. In some other embodiments, the conductive pad 308 may have any suitable shape according to needs. For example, the shape of the conductive pad 308 may include, but is not limited to, a rectangle or a polygon.

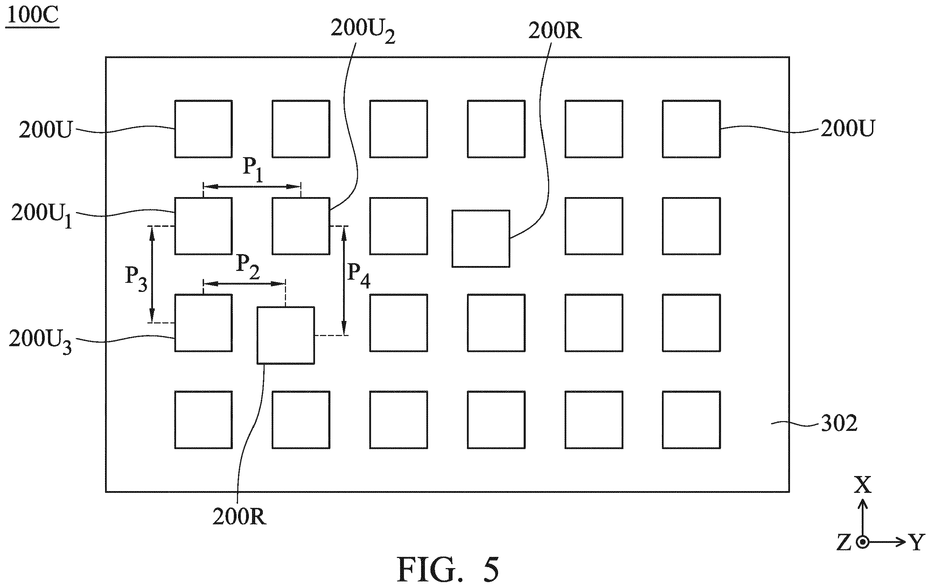

Next, refer to FIG. 5, which is a top-view diagram of an electronic device 100C (the top-view diagram in the X-Y plane) in accordance with some embodiments of the present disclosure. In some embodiments, the electronic device 100C is formed by the method for manufacturing the electronic device 10 as described above. In some embodiments, since the at least part of the plurality of first light-emitting units 200U that are originally disposed on the first substrate 102 is manufactured or arranged by, for example, a photolithography process, the deviation of the pitch between the at least part of the plurality of first light-emitting units 200U that are originally disposed on the first substrate 102 is smaller (for example, in a range smaller than about ±5µm, but it is not limited thereto). On the other hand, as described above, the replaced second light-emitting unit 200R may be placed, for example, by the device 306. Since the deviation of the pitch that can be controlled by the machine of the device 306 itself is larger (for example, in a range smaller than about ±15 µm, but it is not limited thereto). Therefore, in some embodiments, the pitch between one of the at least part of the plurality of first light-emitting units 200U and the second light-emitting 200R on the second substrate 302 may be different from the pitch between the at least part of the plurality of first light-emitting units 200U on the second substrate 302.

The term "pitch" as used herein may be defined as the distance between a center point of a region (pixel) of one light-emitting unit and a center point of a region (pixel) of another light-emitting unit that is adjacent to the one light-emitting unit. Alternatively, the term "pitch" may be defined as the distance between a left edge of a region (pixel) of one light-emitting unit and a left edge of a region (pixel) of another light-emitting unit that is adjacent to the one light-emitting unit. It should be noted that the above two light-emitting units emit the same (or almost the same viewed by most of people) color of light (e.g., red light, green light or blue light and so on, but it is not limited thereto). In addition, an area of one light-emitting unit may be defined as the boundary of the first semiconductor layer 202 of the light-emitting unit structure from a top-view perspective.

In some embodiments, there is a first pitch P₁ between one first light-emitting unit 200U (indicated as 200U₁ for clear explanation) and another first light-emitting unit 200U (indicated as 200U₂) that is adjacent to the one first light-emitting unit 200U (200Ui) along the first direction (Y direction). The first pitch P₁ is defined as the distance between the center point of the first light-emitting unit 200U₁ and the center point of the first light-emitting unit 200U₂ along the first direction (Y direction). Alternatively, the first pitch P₁ is defined as the distance between the left edge of the first light-emitting unit 200U₁ and the left edge of the first light-emitting unit 200U₂ along the first direction (Y direction). In some embodiments, there is a second pitch P₂ between one first light-emitting unit 200U (indicated as 200U₃) and one second light-emitting unit 200R that is adjacent to the first light-emitting unit 200U₃ along the first direction (Y direction). The second pitch P₂ is defined as the distance between the center point of the first light-emitting unit 200U₃ and the center point of the second light-emitting unit 200R along the first direction (Y direction). Alternatively, the second pitch P₂ is defined as the distance between the left edge of the first light-emitting unit 200U₃ and the left edge of the second light-emitting unit 200R along the first direction (Y direction). In some embodiments, the first pitch P₁ may be different from the second pitch P₂. In some embodiments, the difference between the first pitch P₁ and the second pitch P₂ may be in a range from about 0.1µm to about 20µm. In some embodiments, the difference between the first pitch P₁ and the second pitch P₂ may be in a range from about 1µm to about 20µm.

In addition, in some embodiments, there is a third pitch P₃ between one first light-emitting unit 200U (indicated as 200U₁) and another first light-emitting unit 200U (indicated as 200U₃) that is adjacent to the one first light-emitting unit 200U (200Ui) along a second direction (X direction). The second direction is substantially perpendicular to the first direction. The third pitch P₃ is defined as the distance between the center point of the first light-emitting unit 200U₁ and the center point of the first light-emitting unit 200U₃ along the second direction (X direction). Alternatively, the third pitch P₃ is defined as the distance between the upper edge of the first light-emitting unit 200U₁ and the upper edge of the first light-emitting unit 200U₃ along the second direction (X direction). In some embodiments, there is a fourth pitch P₄ between one first light-emitting unit 200U (indicated as 200U₂) and one second light-emitting unit 200R that is adjacent to the first light-emitting unit 200U₂ along the second direction (X direction). The fourth pitch P₄ is defined as the distance between the center point of the first light-emitting unit 200U₂ and the center point of the second light-emitting unit 200R along the second direction (X direction). Alternatively, the fourth pitch P₄ is defined as the distance between the upper edge of the first light-emitting unit 200U₂ and the upper edge of the second light-emitting unit 200R along the second direction (X direction). In some embodiments, the third pitch P₃ may be different from the fourth pitch P₄. In some embodiments, the difference between the third pitch P₃ and the fourth pitch P₄ may be in a range from about 0.1 µm to about 20µm. In some embodiments, the difference between the third pitch P₃ and the fourth pitch P₄ may be in a range from about 1µm to about 20µm.

In the embodiment shown in FIG. 5, the first light-emitting unit 200U (including the at least part of the plurality of first light-emitting units 200U₁ to 200U₃) and the second light-emitting unit 200R that emit the same (or almost the same) color of light (e.g., blue light, but it is not limited thereto) are selected to compare the first pitch P₁ and the second pitch P₂ or to compare the third pitch P₃ and the fourth pitch P₄. In some embodiments, the first light-emitting unit 200U (including the at least part of the plurality of first light-emitting units 200U₁ to 200U₃) and the second light-emitting unit 200R may, for example, emit red light, green light, yellow light or white light. In some embodiments, the first light-emitting unit 200U (including the at least part of the plurality of first light-emitting units 200U₁ to 200U₃) or the second light-emitting unit 200R emits blue light, while a wavelength conversion layer (e.g., including quantum dot materials or organic fluorescent materials) may be additionally disposed over the first light-emitting unit 200U (including the at least part of the plurality of first light-emitting units 200U₁ to 200U₃) or the second light-emitting unit 200R. The blue light is excited by the wavelength conversion layer to generate the light of other colors, for example, including red light or green light, but it is not limited thereto.

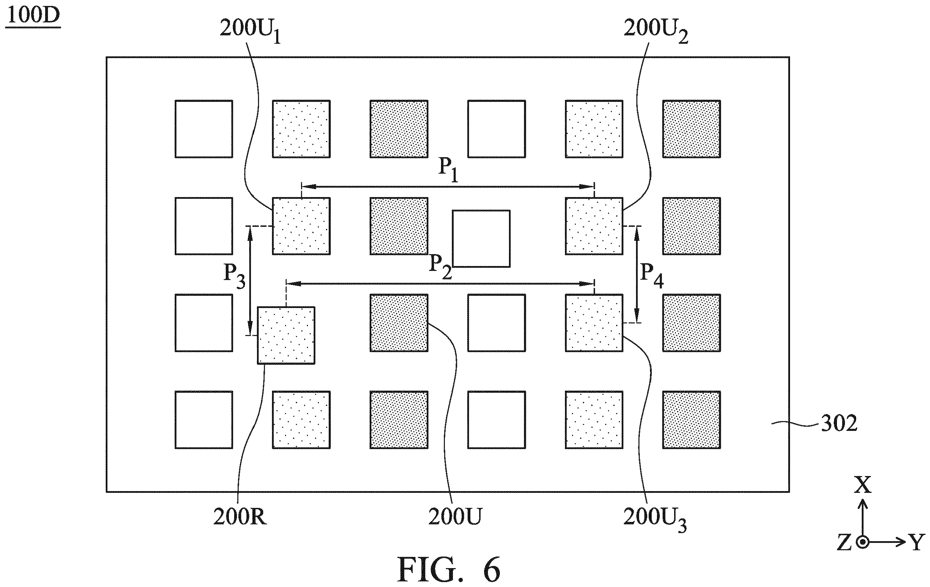

Next, refer to FIG. 6, which is a top-view diagram of an electronic device 100D (the top-view diagram in the X-Y plane) in accordance with some embodiments of the present disclosure. In the embodiment shown in FIG. 6, the at least part of the plurality of first light-emitting units 200U and the second light-emitting unit 200R of the electronic device 100D may emit the light of different colors. For example, a part of the at least part of the plurality of first light-emitting units 200U or the second light-emitting units 200R may emit red light, a part of the at least part of the plurality of first light-emitting units 200U or the second light-emitting units 200R may emit green light, and a part of the at least part of the plurality of first light-emitting units 200U or the second light-emitting units 200R may emit blue light. For example, the at least part of the plurality of first light-emitting units 200U or the second light-emitting units 200R, which are illustrated with the same pattern, may emit light of the same color.

Similarly, in this embodiment, there is a first pitch P₁ between one first light-emitting unit 200U (indicated as 200U₁) and another first light-emitting unit 200U (indicated as 200U₂) that is adjacent to the first light-emitting unit 200U₁ along the first direction. There is a second pitch P₂ between one first light-emitting unit 200U (indicated as 200U₃) and one second light-emitting unit 200R that is adjacent to the first light-emitting unit 200U₃ along the first direction. In some embodiments, the first pitch P₁ may be different from the second pitch P₂. In some embodiments, the difference between the first pitch P₁ and the second pitch P₂ may be in a range from about 0.1µm to about 20µm. In some embodiments, the difference between the first pitch P₁ and the second pitch P₂ may be in a range from about 1µm to about 20µm.

In addition, in this embodiment, there is a third pitch P₃ between one first light-emitting unit 200U (indicated as 200U₁) and one second light-emitting unit 200R that is adjacent to the one first light-emitting unit 200U₁ along the second direction. There is a fourth pitch P₄ between one first light-emitting unit 200U (indicated as 200U₂) and another first light-emitting unit 200U (indicated as 200U₃) that is adjacent to the first light-emitting unit 200U₂ along the second direction. In some embodiments, the third pitch P₃ may be different from the fourth pitch P₄. In some embodiments, the difference between the third pitch P₃ and the fourth pitch P₄ may be in a range from about 0.1 µm to about 20µm. In some embodiments, the difference between the third pitch P₃ and the fourth pitch P₄ may be in a range from about 1 µm to about 20µm.

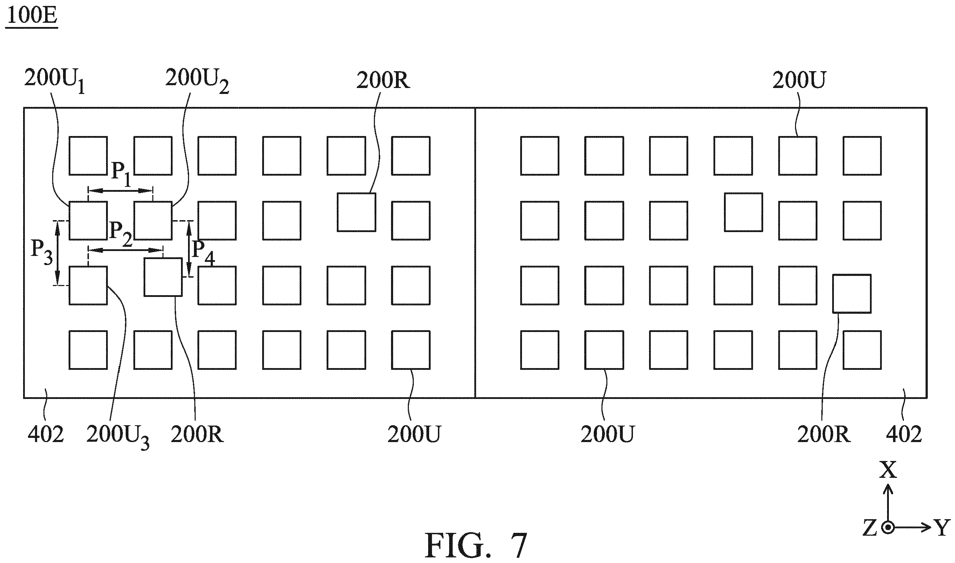

Next, refer to FIG. 7, which is a top-view diagram of an electronic device 100E (the top-view diagram in the X-Y plane) in accordance with some embodiments of the present disclosure. The embodiment shown in FIG. 7 is similar to the embodiment shown in FIG. 5, and the difference between them is that the electronic device 100E shown in FIG. 7 is a tiled electronic device. As shown in FIG. 7, the at least part of the plurality of first light-emitting units 200U and the second light-emitting units 200R are disposed on adjacent but different third substrates 402.

To summarize the above, in accordance with some embodiments of the present disclosure, the method for manufacturing the electronic device can replace (or repair) the light-emitting units in batches. Specifically, the method provided in the present disclosure can replace several light-emitting units at the same time and be unrestricted by the size of the light-emitting unit, and therefore can be applied to the light-emitting units of various sizes. In addition, the method can improve the replacement efficiency or yield of the light-emitting unit in a micro LED device.

Although some embodiments of the present disclosure and their advantages have been described in detail, it should be understood that various changes, substitutions and alterations can be made herein without departing from the spirit and scope of the disclosure as defined by the appended claims. For example, it will be readily understood by one of ordinary skill in the art that many of the features, functions, processes, and materials described herein may be varied while remaining within the scope of the present disclosure. Moreover, the scope of the present application is not intended to be limited to the particular embodiments of the process, machine, manufacture, composition of matter, means, methods and steps described in the specification. As one of ordinary skill in the art will readily appreciate from the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure. Accordingly, the appended claims are intended to include within their scope such processes, machines, manufacture, compositions of matter, means, methods, or steps. Moreover, the scope of each claim in claim configured to build a separate embodiment, and the scope of the present disclosure also includes the various combinations of the claims and the embodiments. The scope of the present disclosure is defined by the appended claims.

## Claims

1. An electronic device (100A, 100B, 100C, 100D, 100E), comprising:
a substrate (302); and
a first light-emitting unit (200U₁), a second light-emitting unit (200U₂), a third light-emitting unit (200U₃) and a fourth light-emitting unit (200R) disposed on the substrate;
wherein the second light-emitting unit is adjacent to the first light-emitting unit along a first direction, the fourth light-emitting unit is adjacent to the third light-emitting unit along the first direction, the third light-emitting unit is adjacent to the first light-emitting unit along a second direction which is perpendicular to the first direction, and the fourth light-emitting unit is adjacent to the second light-emitting unit along the second direction,
wherein a first pitch (P₁) between the first light-emitting unit and the second light-emitting unit is different from a second pitch (P₂) between the third light-emitting unit and the fourth light-emitting unit.

2. The electronic device as claimed in claim 1, wherein a third pitch (P₃) between the first light-emitting unit and the third light-emitting unit is different from a fourth pitch (P₄) between the second light-emitting unit and the fourth light-emitting unit.

3. The electronic device as claimed in claim 1 or 2, wherein the difference between the first pitch and the second pitch is in a range from 0.1µm to 20µm.

4. The electronic device as claimed in claim 2 or 3, wherein the difference between the third pitch and the fourth pitch is in a range from 0.1µm to 20µm.

5. The electronic device as claimed in any of claims 1 to 4, further comprising an adhesive layer (304) disposed on the substrate, wherein the first light-emitting unit, the second light-emitting unit, the third light-emitting unit and the fourth light-emitting unit are partially embedded in the adhesive layer.

6. The electronic device as claimed in claim 5, further comprising a conductive pad (308) disposed on the substrate, and the adhesive layer further comprising a plurality of conductive particles (304p) that are arranged in a pattern.

7. The electronic device as claimed in claim 6, wherein the plurality of conductive particles are arranged corresponding to the conductive pad.

8. A method for manufacturing an electronic device, comprising:
testing a plurality of first light-emitting units (200U) on a first substrate (102) to select one that is to be replaced;
removing the one of the plurality of first light-emitting units (200U') from the first substrate so that the first substrate has a vacant position (VC);
transferring a second light-emitting unit (200R) to a second substrate (302); and
transferring at least part of the plurality of first light-emitting units (200U) that are not replaced from the first substrate to the second substrate,
wherein the vacant position on the first substrate corresponds to the second light-emitting unit.

9. The method for manufacturing an electronic device as claimed in claim 8, further comprising:
forming an adhesive layer (304) on the second substrate before transferring the second light-emitting unit to the second substrate.

10. The method for manufacturing an electronic device as claimed in claim 9, 2 wherein the second light-emitting unit and the at least part of the plurality of first light-emitting units are temporarily positioned in the adhesive layer after having been transferred to the second substrate.

11. The method for manufacturing an electronic device as claimed in any of claims 9 to 10, wherein the adhesive layer comprises a plurality of conductive particles (304p) that are arranged in a pattern.

12. The method for manufacturing an electronic device as claimed in any of claims 8 to 11, further comprising:
transferring the at least part of the plurality of first light-emitting units and the second light-emitting unit from the second substrate to a third substrate (402), wherein the third substrate is an array substrate.

13. The method for manufacturing an electronic device as claimed in any of claims 8 to 12, further comprising:
performing a cleaning process (CL) on light-emitting surfaces of the at least part of the plurality of first light-emitting units and the second light-emitting unit.

14. The method for manufacturing an electronic device as claimed in any of claims 8 to 13, wherein the second light-emitting unit is transferred to the second substrate prior to transferring the at least part of the plurality of first light-emitting units to the second substrate.

15. The method for manufacturing an electronic device as claimed in any of claims 8 to 14 wherein the at least part of the plurality of first light-emitting units are transferred to the second substrate prior to transferring the second light-emitting unit to the second substrate.
